# EUROPEAN PATENT SPECIFICATION

(11) **EP 2 437 584 B1**
(45) Date of publication and mention of the grant of the patent: **18.09.2013**
(21) Application number: 10835424.2
(22) Date of filing: 05.10.2010
(51) Int. Cl.: H05K 7/20

(54) **HEAT DISSIPATER, HEAT DISSIPATION METHOD FOR COMMUNICATION DEVICE, AND COMMUNICATION DEVICE**
WÄRMEABLEITER, WÄRMEABLEITUNGSVERFAHREN FÜR EINE KOMMUNIKATIONSVORRICHTUNG UND KOMMUNIKATIONSVORRICHTUNG
DISSIPATEUR THERMIQUE, PROCÉDÉ DE DISSIPATION THERMIQUE POUR DISPOSITIF DE COMMUNICATION ET DISPOSITIF DE COMMUNICATION

(30) Priority: 11.12.2009 CN 200910188859; 25.09.2010 CN 201010290278
(43) Date of publication of application: 04.04.2012
(73) Proprietor: Huawei Technologies Co., Ltd., Guangdong 518129 (CN)
(72) Inventor: FENG, Taqing, Shenzhen Guangdong 518129 (CN); KONG, Xiaoming, Shenzhen Guangdong 518129 (CN); CHEN, Hongliang, Shenzhen Guangdong 518129 (CN); LI, Zhijian, Shenzhen Guangdong 518129 (CN); ZHAI, Liqian, Shenzhen Guangdong 518129 (CN); WU, Qiong, Shenzhen Guangdong 518129 (CN)
(74) Representative: Thun, Clemens
(86) International application number: PCT/CN2010/077570
(87) International publication number: WO 2011/069389

(56) References cited:
- WO-A1-2005/032230
- CN-A- 101 303 206
- CN-A- 101 459 375
- CN-A- 101 566 442
- CN-Y- 201 218 682
- FR-A1- 2 910 779

## Description

### FIELD OF THE INVENTION

The present invention relates to the field of heat dissipation technologies, and in particular, to a heat dissipation device, a heat dissipation method for a communication device, and a communication device.

### BACKGROUND OF THE INVENTION

A heat dissipation device (for example, an outdoor telecommunication equipment room or cabinet) provides a stable and reliable running environment for a communication device. The communication device deployed in the outdoor telecommunication equipment room or cabinet produces a large amount of heat. Therefore, the heat dissipation device is required for controlling the temperature in the equipment room or cabinet.

Generally, an outdoor heat dissipation device uses an air conditioner or heat exchanger to control the internal temperature of the communication device and ensure that the communication device works reliably under an allowed temperature for a long time. The air conditioner is generally used to adjust the temperature in the cabinet. The air conditioner is installed at the rear of the cabinet or directly installed outside the cabinet. The heat exchanger used to control the internal temperature of the communication device is usually a plate type heat exchanger, with fans both inside and outside.

A common air conditioner consumes much energy, accounting for 40-50% of the energy consumption of an entire telecommunication equipment room. In addition, the common air conditioner is unfavorable to energy saving and emission reduction of the heat dissipation device. The heat exchanger used in an outdoor cabinet is externally and internally provided with fans. The external and internal fans also consume energy. Accordingly, the current heat emission mode consumes a large amount of energy, which hinders energy saving and emission reduction of a system.

WO 2005/032230 discloses an apparatus for cooling communication equipment which comprises a heat pipe for transferring heat generated in a heat-emitting unit of the communication equipment and being mounted on a predetermined location of the heat-emitting unit; a vaporizing unit for vaporizing liquid with the heat transferred via the heat pipe and draining the vaporized liquid through a vaporization line, wherein a lower part of the vaporizing unit contacts a predetermined location of the heat pipe; a condensing unit for performing heat-exchange by condensing the vaporized liquid from the vaporizing unit and returning the condensed liquid to the vaporizing unit through a condensation line; and a small capacity fan for releasing air to the outside when the condensing unit performs the heat-exchange.

CN 101303206 discloses a communication base station square cabinet heat dissipating device, including a hot tube bank composed of two heat pipes, the evaporation segment and the condense segment of the heat pipe are located at inside and outside of the square cabinet respectively. A water tank is placed on the outside of the square cabinet, the condense segment of the heat pipe is located below the surface of water in the water tank. Another heat dissipating device providing on the outer surface of the water tank includes two heat pipes, the evaporation segment of which is located below the surface of water in the water tank and the condense segment of which is located in the outside of the water tank.

### SUMMARY OF THE INVENTION

Embodiments of the present invention provide a heat dissipation device, a heat dissipation method for a communication device, and a communication device to improve effects of energy saving and emission reduction of a system.

An embodiment of the present invention provide a heat dissipation device, including a closed shell and a temperature control device; where the temperature control device includes:
a cold storage medium module, a first group of thermosiphons, a second group thermosiphons, and an auxiliary medium cooler; where the cold storage medium module is disposed at the outside of the closed shell, the first group thermosiphons are provided with a first group of evaporation ends and a first group of condensation ends, the second group of thermosiphons are provided with a second group of evaporation ends and a second group of condensation ends, and the auxiliary medium cooler is connected to the cold storage medium module by using a connection tube, wherein the cold storage medium module is internally provided with a cold storage medium, and the first group of thermosiphons and the second group of thermosiphons are filled with thermally-vaporized liquid;
where the first group of evaporation ends are disposed at the inside of the closed shell, and the first group of condensation ends are disposed in the cold storage medium module; the second group of evaporation ends are disposed in the cold storage medium module, and the second group of condensation ends are disposed in environmental air; the first group of condensation ends are disposed above the first group of evaporation ends in the direction of gravity, and the second group of condensation ends are disposed above the second group of evaporation ends in the direction of gravity.

An embodiment of the present invention provides a heat dissipation method for a communication device, where the method includes:
absorbing air heat inside the communication device by using a second group of evaporation ends of a first group of thermosiphons;
exchanging the air heat absorbed by the first group of evaporation ends with the cold storage medium module by using the first condensation ends of the first group of thermosiphons, and absorbing, by using a cold storage medium in the cold storage medium module, the heat emitted by the first group of condensation ends during a heat exchange, where the first group of condensation ends are disposed above the first group of condensation ends in the direction of gravity;
absorbing, by using the second group of evaporation ends of the second group of thermosiphons, the heat absorbed by the cold storage medium, and emitting, by using the second group of condensation ends of the second group of thermosiphons, the heat absorbed by the second group of evaporation ends to the environmental air, where the second group of condensation ends are disposed in the environmental air and are disposed above the second group of evaporation ends in the direction of gravity, and
providing a supplementary cold storage quantity for the cold storage medium module by using an auxiliary medium cooler,
wherein the cold storage medium module is internally provided with a cold storage medium, and the first group of thermosiphons and the second group of thermosiphons are filled with thermally-vaporized liquid.

An embodiment of the present invention provides a communication device, where the communication device includes: a at least one internal communication device and a head dissipation device according to an embodiment of the present invention; wherein said internal communication device is disposed at the inside of the closed shell, the temperature control device is configured to enable the internal communication device to run under an allowed temperature.

According to the technical solution provided in the embodiments of the present invention, the first group of evaporation ends of the first group of thermosiphons absorb the air heat at the inside of the communication device; the heat absorbed by the first group of evaporation ends is exchanged with the cold storage medium module by using the first condensation ends; and the second group of evaporation ends absorb the heat of the cold storage medium module and the absorbed heat is emitted to the environmental air by using the second group of condensation ends. In this manner, the heat dissipation device does not depend on the air conditioner and fans, and the energy consumption of the air conditioner is reduced, which improves the effects of energy saving and emission reduction.

An embodiment of the present invention provides a heat dissipation device, including: a cold storage medium module, an integrated group of thermosiphons, a first vent, and a second vent.

The integrated group of thermosiphons are disposed through the cold storage medium module in the direction of gravity; a lower section of the integrated group of thermosiphons is disposed below the cold storage medium module and in the first vent; a middle section of the integrated group of thermosiphons is disposed in the cold storage medium module; an upper section of the integrated group of thermosiphons is disposed above the cold storage medium module and in the second vent; the heat produced by the communication device provided with the heat dissipation device is transferred to the lower section of the integrated group of thermosiphons by using the first vent, the heat is deposited in the cold storage medium module by using the middle section of the integrated group of thermosiphons, and the heat deposited in the cold storage medium module is exchanged by the upper section of the integrated group of thermosiphons with the environmental air by using the second vent, wherein the cold storage medium module is internally provided with a cold storage medium, and the integrated group of thermosiphons are filled with thermally-vaporized liquid.

An embodiment of the present invention provides a communication device combination, including a communication device, and a heat dissipation device according to an embodiment of the present invention.

According to the above technical solution, outdoor communication device does not depend on the air conditioner and the energy consumption of the air conditioner is reduced, which improves the effects of energy saving and emission reduction. The heat dissipation device implements heat dissipation by using the temperature difference, which reduces the drive and improves the maintainability.

### BRIEF DESCRIPTION OF THE DRAWINGS

To make the technical solution of the present invention clearer, the accompanying drawings for illustrating various embodiments of the present invention are briefly introduced below. Apparently, the accompanying drawings are for the exemplary purpose, and people skilled in the art may derive other drawings from such accompanying drawings without creative efforts.
FIG 1 is a structural diagram of a heat dissipation device according to an embodiment of the present invention;
FIG 2 is a structural diagram of a heat dissipation device according to an embodiment of the present invention;
FIG 3 is a structural diagram of a heat dissipation device according to an embodiment of the present invention;
FIG 4 is a structural diagram of a communication device according to an embodiment of the present invention;
FIG 5 is a structural diagram of a communication device according to an embodiment of the present invention;
FIG 6 is a flow chart of a heat dissipation method for a communication device according to an embodiment of the present invention;
FIG 7 is a flow chart of a heat dissipation method for a communication device according to an embodiment of the present invention;
FIG 8 is a structural diagram of a heat dissipation device according to an embodiment of the present invention; and
FIG 9 is a schematic structural diagram of a combined communication device according to an embodiment of the present invention.

### DETAILED DESCRIPTION OF THE EMBODIMENTS

In order to make the technical solution of the present invention clearer, the accompanying drawings that are needed in the embodiments are briefly introduced below. Evidently, the embodiments are exemplary, without covering all embodiments of the present invention. Persons skilled in the art may derive other embodiments from the embodiments given herein without making creative efforts, and all such embodiments are covered in the scope of the present invention.

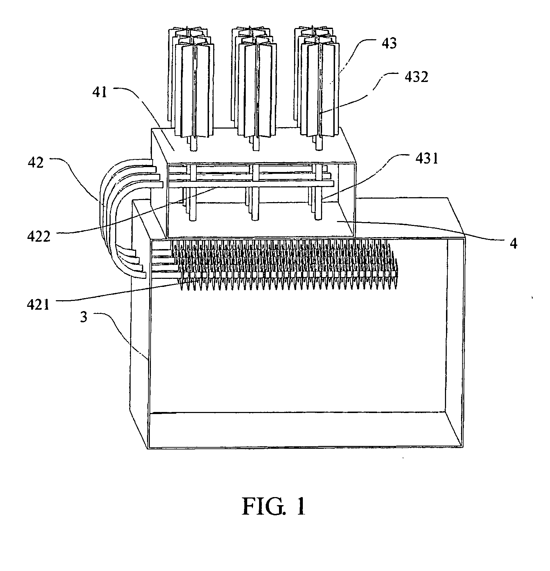

As shown in FIG 1, a heat dissipation device provided in an embodiment of the present invention includes a closed shell 3 and a temperature control device 4. The temperature control device 4 includes:
a cold storage medium module 41, a first group of thermosiphons 42, and a second group of thermosiphons 43.The cold storage medium module 41 is disposed at the outside of the closed shell 3 of the heat dissipation device, the first group thermosiphons 42 are provided with a first group of evaporation ends 421 and a first group of condensation ends 422, and the second group of thermosiphons 43 are provided with a second group of evaporation ends 431 and a second group of condensation ends 432.

The first group of evaporation ends 421 are disposed at the inside of the closed shell 3 of the heat dissipation device. The first group of condensation ends 422 are disposed in the cold storage medium module 41. The second group of evaporation ends 431 are disposed in the cold storage medium module 41. The second group of condensation ends 432 are disposed in the environmental air. The first group of condensation ends 422 are disposed above the first group of evaporation ends 421 in the direction of gravity, and the second group of condensation ends 432 are disposed above the second group of evaporation ends 431 in the direction of gravity.

Further, a cold storage medium is placed in the cold storage medium module 41. The cold storage medium may be water in one embodiment, may be ethylene glycol solution in another embodiment, or may be other engineering liquid materials still in another embodiment. Embodiments of the present invention do not make a special limitation.

The cold storage medium module 41 may be a water tank in one embodiment, may be a cold storage ethylene glycol solution tank in another embodiment, or may be other cold storage engineering liquid material tanks in still another embodiment.

In one embodiment, the shell of the cold storage medium module 41 may be thermal insulation materials or thermal-insulation protection layers. A thermal insulation shell or layer may reduce a direct thermal exchange between the cold storage medium module 41 and the environmental air, and may reduce the influence of the solar radiation.

The first group of thermosiphons 42 is made of metal. The metal may be aluminum in one embodiment, may be copper in another embodiment, may be aluminum alloy or copper alloy till in another embodiment, or may be steel in still another embodiment. The embodiments of the present invention do not make a special limitation.

In one embodiment, the first group of thermosiphons 42 is filled with thermally-vaporized liquid. The thermally-vaporized liquid may be a substance such as ammonia, acetone, or R134A refrigerant.

The second group of thermosiphons 43 are made of metal. The metal may be alumina in one embodiment, copper in another embodiment, aluminum alloy or copper alloy in still another embodiment, or steel in still another embodiment. The metal is not limited in the embodiments of the present invention.

In one embodiment, the second group of thermosiphons 43 are filled with thermally-vaporized liquid. The thermally-vaporized liquid filled in the second group of thermosiphons 43 may be a substance such as ammonia, acetone, or R134A refrigerant.

Further, as shown in FIG 1, the first group of evaporation ends 421 are externally provided with fins to strengthen the heat exchange with the air. It is understandable that the first group of condensation ends 422 disposed in the cold storage medium module 41 may also be provided with fins according to a situation.

Further, as shown in FIG 1, the second group of evaporation ends 432 are externally provided with fins to strengthen the heat exchange with the air. It is understandable that the second group of evaporation ends 431 in the cold storage medium module 41 may also be provided with fins according to a situation.

According to this embodiment, a heat dissipation device may be an outdoor telecommunication equipment room or an outdoor communication cabinet.

The working principles are described in detail with reference to FIG 1.

When the outdoor temperature is higher than the temperature of the cold storage medium in the cold storage medium module 41 (for example, during the day), the heat produced by the communication device at the inside of the heat dissipation device enables the air temperature at the inside of the heat dissipation device to rise. The first group of thermosiphons 42 absorb air heat by using the first group of evaporation ends 421 with fins. The absorbed air heat is emitted by using the first group of condensation ends 422 disposed in the cold storage medium module 41, and the emitted heat is absorbed by the cold storage medium in the cold storage medium module 41.

When the first group of thermosiphons 42 absorb the air heat by using the first group of evaporation ends 421 with fins, the liquid in the first group of thermosiphons 42 evaporates into vapor because the first group of thermosiphons 42 are filled with thermally-vaporized liquid. The vapor arrives, along the first group of thermosiphons 42, at the first group of condensation ends 422 of the first group of thermosiphons. The first group of condensation ends 422 are disposed in the cold storage medium module 41. Therefore, the cold storage medium in the cold storage medium module 41 absorbs the heat carried by the vapor. In this manner, the vapor from the first group of thermosiphons is condensed to liquid after the heat exchange. The first group of condensation ends 422 are disposed above the first group of evaporation ends 421 in the direction of gravity. Therefore, the liquid flows back from the first group of condensation ends 422 to the first group of evaporation ends 421.

The temperature of the cold storage medium in the cold storage medium module 41 gradually rises due to continuous heat absorption. When the outdoor temperature is lower than the temperature of the cold storage medium in the cold storage medium module 41 (for example, during the night), the second group of thermosiphons 43 absorb heat of the cold storage medium by using the second group of evaporation ends 431. The absorbed heat is emitted to the environmental air by using the second group of condensation ends 432 disposed at the environmental air. In this case, the temperature of the cold storage medium is gradually decreased. This continuous cycle may ensure that the communication device at the inside of the heat dissipation device reliably works at an allowable temperature for a long time.

The second group of thermosiphons 43 are filled with thermally-vaporized liquid. Therefore, when the second group of thermosiphons 43 absorb heat from the cold storage medium module by using the second group of condensation ends 431, the liquid in the second group of thermosiphons 43 evaporates into vapor when the liquid is heated. The vapor arrives, along the second group of thermosiphons 42, at the second group of condensation ends 432 of the second group of thermosiphons. The second group of condensation ends 432 are disposed in the environmental air. In this case, the vapor in the second group of condensation ends 432 exchanges heat with the environmental air, and the heat carried by the vapor is emitted into the environmental air. Therefore, the temperature of the cold storage medium is gradually decreased. After the heat exchange, the vapor in the second group of thermosiphons is condensed to liquid.

The liquid may flow back from the second group of condensation ends 432 to the second group of evaporation ends 431 for the heat dissipation next time because the second group of condensation ends 432 are disposed above the second group of evaporation ends 431 in the direction of gravity.

The first group of condensation ends 422 are disposed above the first group of evaporation ends 421 in the direction of gravity; and the second group of condensation ends 432 are above the second group of evaporation ends 431 in the direction of gravity. Therefore, the first group of thermosiphons 42 and the second group of thermosiphons 43 work in a unidirectional thermal transfer mode, which ensures that the heat outside the telecommunication equipment room does not permeate into the telecommunication equipment room by using thermotubes when the outdoor temperature is high. Meanwhile, the shell of the cold storage medium module 41 is made of thermal insulation materials or thermal-insulation protection layers, which reduces the case that the cold storage medium is heated by the environment through the shell and ensures unidirectional heat dissipation between the cold medium and the environmental air only by using the second group of thermosiphons 43.

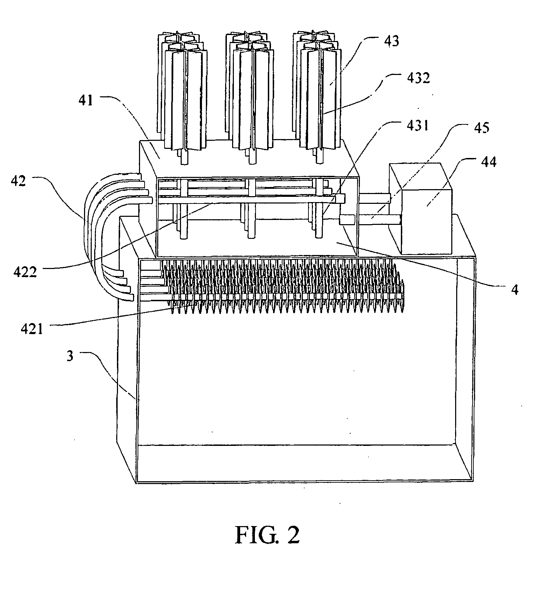

Further, as shown in FIG 2, according to another embodiment, the temperature control device 4 may further include an auxiliary medium cooler 44 which is connected to the cold storage medium module 41 by using a connection tube 45.The auxiliary medium cooler 44 is configured to provide a supplementary cold storage quantity when the temperature difference during the night is not great or an absolute temperature is excessively high and the temperature of the cold storage medium in the cold storage medium module 41 may not reach the cold storage quantity for dissipation during the day. Further, in an embodiment, the auxiliary medium cooler 44 is set to only work at a low temperature during the night so as to improve coefficient of performance (COP).

It should be noted that the first group of thermosiphons 42 may be common thermosiphons or gravity loop thermotubes, or separated gravity themotubes.

It should be noted that the second group of thermosiphons 43 may be common thermosiphons or gravity loop thermotubes, or separated gravity themotubes in an embodiment.

According to the technical solution provided in the embodiments of the present invention, by using the temperature control device including the cold storage medium module, the first group of thermosiphons, and the second group of thermosiphons and the temperature different between day and night, an outdoor heat dissipation device does not depend on the air conditioner, which improves effects of energy saving and emission reduction. The temperature control device does not require drive so that the maintainability is improved. In addition, the temperature control device does not include a fan system, and therefore system noises are effectively reduced. Further, the auxiliary medium cooler is provided to provide a supplementary cold storage quantity when the temperature difference during the night is not great or the absolute temperature is excessively high and the temperature of the cold storage medium in the cold storage medium module may not reach the cold storage quantity for dissipation during the day.

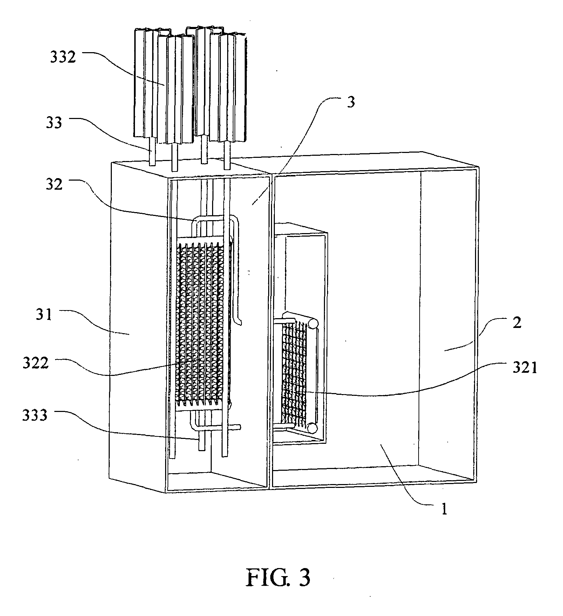

As shown in FIG 3, a heat dissipation device provided in an embodiment of the present invention includes a closed shell 2 and a temperature control device 3. The temperature control device 3 includes:
a cold storage medium module 31, a first group of thermosiphons 32, and a second group of thermosiphons 33.The cold storage medium module 31 is disposed at the outside of the closed shell 3 of the heat dissipation device, the first group of thermosiphons 32 are provided with a first group of evaporation ends 321 and a first group of condensation ends 322, and the second group of thermosiphons 33 are provided with a second group of evaporation ends 331 and a second group of condensation ends 332.

The first group of evaporation ends 321 are disposed at the inside of the closed shell 2 of the heat dissipation device, and the first group of condensation ends 322 are disposed in the cold storage medium module 31. The second group of evaporation ends 331 are disposed in the cold storage medium module 31, and the second group of condensation ends 332 are disposed in the environmental air. The first group of condensation ends 322 are disposed above the first group of evaporation ends 321 in the direction of gravity. The second group of condensation ends 332 are disposed above the second group of evaporation ends 331 in the direction of gravity.

It should be noted that the first group of thermosiphons 32 may be common thermosiphons or gravity loop thermotubes, or separated gravity themotubes in an embodiment.

It should be noted that the second group of thermosiphons 33 may be common thermosiphons or gravity loop thermotubes, or separated gravity themotubes in one embodiment.

The working principles provided in this embodiment are similar to those described in the above embodiment, which are not detailed here.

It is understandable that the heat dissipation device provided in this embodiment may include at least one internal communication device.

In one embodiment, the heat dissipation device may be an outdoor telecommunication equipment room or an outdoor communication cabinet.

According to the technical solution provided in the embodiments of the present invention, by using the temperature control device including the cold storage medium module, the first group of thermosiphons, and the second group of thermosiphons and the temperature different between day and night, the outdoor heat dissipation device does not depend on the air conditioner, which improves the effects of energy saving and emission reduction. The temperature control device does not require drive so that the maintainability is improved. In addition, the temperature control device does not include a fan system, and therefore the system noises are effectively reduced.

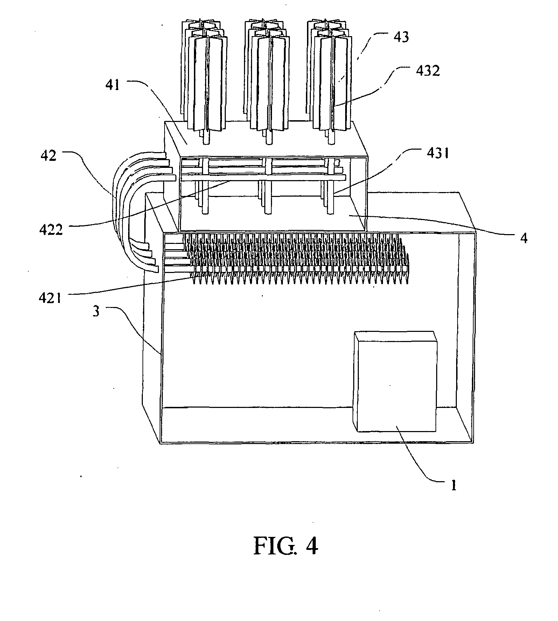

As shown in FIG 4, a communication device provided in an embodiment of the present invention includes: a closed shell 3, a temperature control device 4, and at least one internal communication device 1; where the internal communication device 1 is disposed at the inside of the closed shell 3, the temperature control device 4 is configured to enable the internal communication device 1 to run under an allowed temperature, and the temperature control device 4 includes:
a cold storage medium module 41, a first group of thermosiphons 42, and a second group of thermosiphons 43.The cold storage medium module 41 is disposed at the outside of the closed shell 3 of the heat dissipation device, the first group of thermosiphons 42 are provided with a first group of evaporation ends 421 and a first group of condensation ends 422, and the second group of thermosiphons 43 are provided with a second group of evaporation ends 431 and a second group of condensation ends 432.

The first group of evaporation ends 421 are disposed at the inside of the closed shell 3 of the heat dissipation device, and the first group of condensation ends 422 are disposed in the cold storage medium module 41. The second group of evaporation ends 431 are disposed in the cold storage medium module 41, and the second group of condensation ends 432 are disposed in the environmental air. The first group of condensation ends 422 are disposed above the first group of evaporation ends 421 in the direction of gravity. The second group of condensation ends 432 are disposed above the second group of evaporation ends 431 in the direction of gravity.

Further, the cold storage medium module 41 is internally provided with a cold storage medium. The cold storage medium may be water in one embodiment, or ethylene glycol solution in another embodiment, or other engineering liquid materials in still another embodiment. The cold storage medium is not limited in the embodiments of the present invention

The cold storage medium module 41 may be a water tank in one embodiment, may be a cold storage ethylene glycol solution tank in another embodiment, or may be other cold storage engineering liquid material tank in still another embodiment.

In one embodiment, the shell of the cold storage medium module 41 may be thermal insulation materials or thermal-insulation protection layers. The thermal insulation shell or layer may reduce a direct thermal exchange between the cold storage medium module 41 and the environmental air, and may reduce the influence of the solar radiation

The first group of thermosiphons 42 are made of metal. The metal may be alumina in one embodiment, copper in another embodiment, aluminum alloy or copper alloy in still another embodiment, or steel in still another embodiment. The metal is not limited in the embodiments of the present invention.

In one embodiment, the first group of thermosiphons 42 are filled with thermally-vaporized liquid. The thermally-vaporized liquid may be a substance such as ammonia, acetone, or R134A refrigerant (1,1,1,2-tetrafluoroethane).

The second group of thermosiphons 43 are made of metal. The metal may be alumina in one embodiment, copper in another embodiment, aluminum alloy or copper alloy in still another embodiment, or steel in still another embodiment. The metal is not limited in the embodiments of the present invention.

In one embodiment, the second group of thermosiphons 43 are filled with thermally-vaporized liquid. The thermally-vaporized liquid may be a substance such as ammonia, acetone, or R134A refrigerant.

Further, as shown in FIG 4, the first group of evaporation ends 421 are externally provided with fins to strengthen the heat exchange with the air. It can be understood that the first group of condensation ends 422 in the cold storage medium module 1. The condensation ends 422 may also be provided with fins as required.

Further, as shown in FIG 4, the second group of evaporation ends 432 are externally provided with fins to strengthen the heat exchange with the air. It can be understood that the second group of evaporation ends 431 in the cold storage medium module 1. The evaporation ends 431 may also be provided with fins as required.

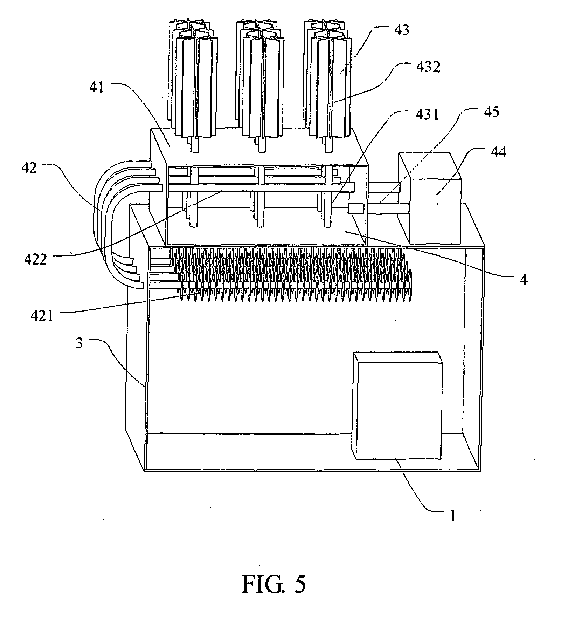

Further, as shown in FIG 5, in another embodiment, the temperature control device may include an auxiliary medium cooler 44. The auxiliary medium cooler 44 is connected to the cold storage medium module by using a connecting pipe 45.The auxiliary medium cooler 44 is configured to provide a supplementary cold storage quantity when the temperature difference during the night is not great or the absolute temperature is excessively high and the temperature of the cold storage medium in the cold storage medium module 41 cannot reach the cold storage quantity for dissipation during the day. Further, in an embodiment, the auxiliary medium cooler 44 is set to only work during the night when the temperature is low.

It should be noted that the first group of thermosiphons 42 may be common thermosiphons or gravity loop thermotubes, or separated gravity themotubes in an embodiment.

It should be noted that the second group of thermosiphons 43 may be common thermosiphons or gravity loop thermotubes, or separated gravity themotubes in one embodiment.

According to the technical solution provided in the embodiments of the present invention, by using the temperature control device including the cold storage medium module, the first group of thermosiphons, and the second group of thermosiphons and the temperature different between day and night, the outdoor heat dissipation device does not depend on the air conditioner, which improves the effects of energy saving and emission reduction. The temperature control device does not require drive so that the maintainability is improved. In addition, the temperature control device does not include a fan system, and therefore the system noises are effectively reduced.

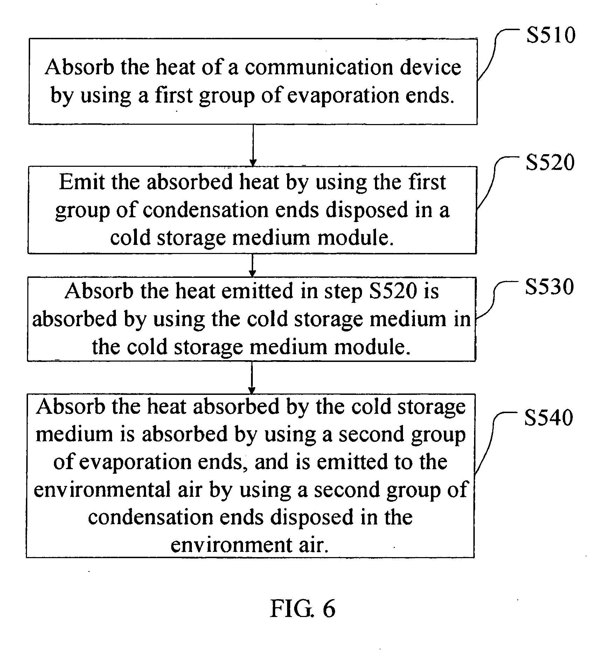

As shown in FIG 6, a heat dissipation method for a communication device provided in an embodiment of the present invention includes:
S510: Absorb air heat inside the communication device by using a second group of evaporation ends of a first group of thermosiphons.
S520: Exchange the air heat absorbed by the first group of evaporation ends with the cold storage medium module by using the first condensation ends of the first group of thermosiphons, and absorb, by using the cold storage medium in the cold storage medium module, the heat emitted by the first group of condensation ends during the heat exchange.

After the cold storage medium in the cold storage medium module absorbs the heat emitted in step S520, the temperature of the cold storage medium rises gradually due to continuous heat absorption.

S530: The second group of evaporation ends of the second group of thermosiphons absorb the heat absorbed by the cold storage medium, and the heat is emitted to the environmental air by using the second group of condensation ends of the second group of thermosiphons disposed in the environment air.

By step S530, the temperature of the cold storage medium in the cold storage medium module is gradually decreased. Such a continuous cycle may ensure that the communication device works reliably under an allowed temperature for a long time.

It should be noted that the cold storage medium in the cold storage medium module also provides cold storage function in addition to heat transfer function, and applies the quantity of cold stored during the night for heat dissipation in a high temperature period during the day.

It should be noted that the first group of condensation ends are disposed above the first group of evaporation ends in the direction of gravity, and the second group of condensation ends are above the second group of evaporation ends in the direction of gravity.

According to the above technical solution provided in the embodiments of the present invention, heat dissipation of the outdoor communication device does not depend on the air conditioner, which improves the effects of energy saving and emission reduction. The temperature control device does not require drive so that the maintainability is improved. In addition, the temperature control device does not include a fan system, and therefore the system noises are effectively reduced.

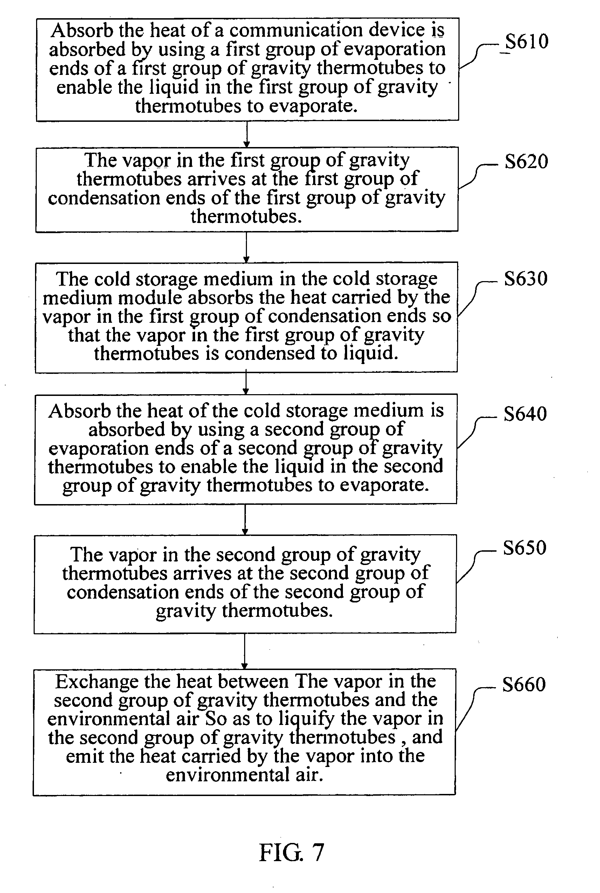

As shown in FIG 7, a heat dissipation method for a communication device provided in an embodiment of the present invention includes:
S610: Absorb the air heat of a communication device by using a first group of evaporation ends of a first group of thermosiphons to enable the liquid in the first group of thermosiphons to evaporate into vapor.
S620: The vapor in the first group of thermosiphons arrives at the first group of condensation ends of the first group of thermosiphons. The first group of condensation ends are disposed in the cold storage medium module and the first group of condensation ends are disposed above the first group of evaporation ends in the direction of gravity.
S630: The cold storage medium in the cold storage medium module absorbs the heat carried by the vapor in the first group of condensation ends so that the vapor in the first group of thermosiphons is condensed to liquid.
S640: Absorb the heat of the cold storage medium by using a second group of evaporation ends of a second group of thermosiphons to enable the liquid in the second group of thermosiphons to evaporate into vapor.
S650: The vapor in the second group of thermosiphons arrives at the second group of condensation ends of the second group of thermosiphons. The second group of condensation ends are disposed in the environmental air and the second group of condensation ends are disposed above the second group of evaporation ends in the direction of gravity.
S660: Exchange the heat between the vapor in the second group of condensation ends and the environmental air so as to liquefy the vapor in the second group of condensation ends, and emit the heat carried by the vapor into the environmental air.

By steps S640-S660, the temperature of the cold storage medium in the cold storage medium module is gradually decreased. Such a continuous cycle may ensure that the communication device works reliably under an allowed temperature for a long time.

It should be noted that the cold storage medium in the cold storage medium module also provides cold storage function in addition to heat transfer function, and applies the quantity of cold stored during the night for heat dissipation in a high temperature period during the day.

It should be noted that the first group of condensation ends are disposed above the first group of evaporation ends in the direction of gravity, and the second group of condensation ends are above the second group of evaporation ends in the direction of gravity. The first group of condensation ends are disposed above the first group of evaporation ends in the direction of gravity. The second group of condensation ends 432 are disposed above the second group of evaporation ends 431 in the direction of gravity. In this manner, the first group of thermosiphons and the second group of thermosiphons work in a unidirectional thermal transfer mode, which ensures that the heat outside the telecommunication equipment room does not permeate into the telecommunication equipment room through thermotubes when the outdoor temperature is high.

According to the above technical solution provided in the embodiments of the present invention, heat dissipation of the outdoor communication device does not depend on the air conditioner, which improves the effects of energy saving and emission reduction. The temperature control device does not require drive so that the maintainability is improved. In addition, the temperature control device does not include a fan system, and therefore the system noises are effectively reduced.

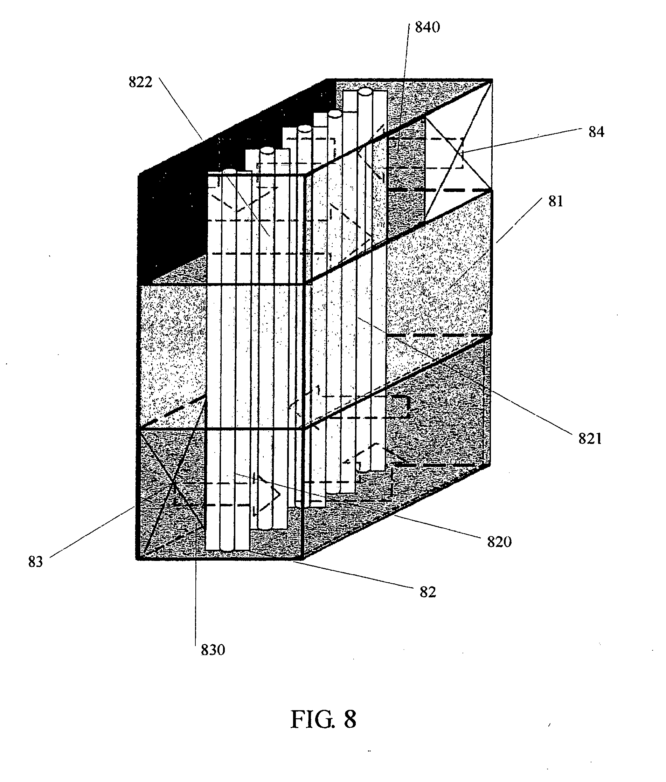

As shown in FIG 8, a heat dissipation device provided in an embodiment of the present invention includes: a cold storage medium module 81, an integrated group of thermosiphons 82, a first vent 830, and a second vent 840.

The integrated group of thermosiphons 82 are disposed through the cold storage medium module 81. A lower section 820 of the integrated group of thermosiphons 82 is disposed below the cold storage medium module 81 and in the first vent 830; a middle section 821 of the integrated group of thermosiphons 82 is disposed in the cold storage medium module; an upper section 822 of the integrated group of thermosiphons 82 is disposed above the cold storage medium module 81 and in the second vent 840.The heat produced by the communication device provided with the heat dissipation device is transferred to the lower section 820 of the integrated group of thermosiphons 82 by using the first vent 830, the heat is deposited in the cold storage medium module 81 by using the middle section 821 of the integrated group of thermosiphons 82, and the heat deposited in the cold storage medium module 81 is exchanged by the upper section 822 of the integrated group of thermosiphons 82 with the environmental air by using the second vent 840.

As show in FIG 8, optionally, in the heat dissipation device provided in an embodiment of the present invention, a first fan module 83 may be disposed in the first vent 830 and a second fan module 84 may be disposed in the second vent 840. In this manner, under the function of the first fan module83, the heat produced by the communication device provided with the heat dissipation device is transferred to the lower section 820 of the integrated group of thermosiphons 82 by using the first vent 830; and the heat of the upper section 822 of the integrated group of thermosiphons 82 is exchanged with the environmental air by using the second fan module 84 disposed in the second vent 840. The fan modules disposed in the first vent 830 and the second vent 840 facilitate heat dissipation of the system.

Optionally, in an embodiment, the inner wall of the second vent 840 is provided with a hole (not shown in FIG 8), which facilitates an air exchange between the air in the second vent 840 and the environmental air so that the upper section 822 of the integrated group of thermosiphons 82 may better exchange heat with the environmental air.

It is understandable that in an embodiment, the integrated group of thermosiphons 82 include at least one integrated thermosiphon.

In an embodiment, the integrated group of thermosiphons 82 are made of metal. The metal may be alumina in one embodiment, copper in another embodiment, aluminum alloy or copper alloy in still another embodiment, or steel in still another embodiment. The metal is not limited in the embodiments of the present invention.

In one embodiment, the integrated group of thermosiphons 82 are filled with thermally-vaporized liquid. The liquid may be a substance such as ammonia, acetone, or R134A refrigerant.

The working principles are described in detail with reference to FIG 8.

Specifically, in an embodiment of the present invention, when the outdoor temperature is higher than the temperature of the cold storage medium in the cold storage medium module 81 (for example, during the day), the heat generated by an external communication device may be transferred to the lower section 820 of the integrated group of thermosiphons 82 by using the first fan module 83( to be specific, the heat produced by the communication device provided with the heat dissipation device, under the function of the first fan module 83, is transferred to the lower section 820 of the integrated group of thermosiphons 82 by using the first vent 830), and the lower section 820 of the integrated group of thermosiphons 82 transfers the heat to the middle section of the integrated group of thermosiphons 82. The middle section 821 of the integrated group of thermosiphons 82 exchanges heat with the cold storage medium module 81, and emits heat. The emitted heat is absorbed by the cold storage medium module 81 and deposited in the cold storage medium module 81.

In an embodiment, when the integrated group of thermosiphons 82 transfers the heat produced by the external communication device to the lower section 820 of the integrated group of thermosiphons 82 by using the first fan module 83, the liquid in the integrated group of thermosiphons 82 evaporates into vapor because the integrated group of thermosiphons 82 are filled with thermally-vaporized liquid. The vapor rises along the lower section 820 of the integrated group of thermosiphons 82 and arrives at the middle section 821 of the integrated group of thermosiphons 82. The middle section 821 of the integrated group of thermosiphons 82 is disposed in the cold storage medium module 81. Therefore, the cold storage medium in the cold storage medium module 81 absorbs the heat carried by the vapor. In this manner, the vapor in the integrated group of thermosiphons 82 is condensed to liquid and flows back, due to the gravity, to the lower section 820 of the integrated group of thermosiphons.

The temperature of the cold storage medium in the cold storage medium module 81 rises as the cold storage medium absorbs heat continuously. When an ambient temperature is lower than the temperature of the cold storage medium in the cold storage medium module 81 (for example, during the night), the heat deposited in the cold storage medium module 81 is transferred to the upper section 812 of the integrated group of thermosiphons 81 by using the upper section 812 of the integrated group of thermosiphons, the upper section 812 of the integrated group of thermosiphons exchanges heat with the environmental air by using the second fan module 84 disposed in the second vent 840. In this manner, the heat is emitted to the environment air so that the temperature of the cold storage medium module is decreased gradually.

In an embodiment, because the integrated group of thermosiphons 82 are filled with thermally-vaporized liquid, when the ambient temperature is lower than the temperature of the cold storage medium in the cold storage medium module 81 (for example, during the night), the middle section of the integrated group of thermosiphons 82 disposed in the cold storage medium module 81 absorbs the heat deposited in the cold storage medium module 81, and the liquid in the middle section of the integrated group of thermosiphons 82 evaporates into vapor when the liquid is heated. The vapor rises along the middle section 821 of the integrated group of thermosiphons 82 and arrives at the upper section 822 of the integrated group of thermosiphons 82. The heat carried by the vapor is emitted into the environmental air by using the second fan module so that the temperature of the cold storage medium module is decreased gradually.

In an embodiment, the cold storage medium module 81 may be a cold storage tank. The cold storage medium contained in the cold storage tank includes but not limited to: water, ice, ethylene glycol solution, or phase change material (PCM).

In an embodiment of the present invention, the shell of the cold storage medium module 81 is made of thermal insulation materials or thermal-insulation protection layers, which reduces the case that the cold storage medium is heated by the environment through the shell and therefore ensures unidirectional heat dissipation between the cold medium and the environment by using integrated group of thermosiphons 82.

In one embodiment, the heat dissipation device may be applicable to the scenario of an outdoor telecommunication equipment room or an outdoor communication cabinet.

In this embodiment, the integrated group of thermosiphons 82 (including multiple integrated thermosiphons) are disposed through the cold storage medium module. The lower section of the integrated group of thermosiphons 82 absorbs heat, the middle section of the integrated group of thermosiphons 82 stores cold, and upper section of the integrated group of thermosiphons 82 dissipates heat, which integrates the function of heat exchange of cold storage.

In this embodiment, the integrated group of thermosiphons 82 are filled with thermally-vaporized liquid and the integrated group of thermosiphons 82 are disposed through the cold storage medium module 81 in the direction of gravity. The thermally-vaporized liquid, when being heated, evaporates into vapor and the vapor rises along the integrated group of thermosiphons 82. In this manner, the integrated group of thermosiphons 82 works in a unidictional phase change heat transfer mode. When applied to the scenario of the telecommunication equipment room or cabinet, the integrated group of thermosiphons ensures that the heat of the telecommunication equipment room or cabinet is emitted to the environmental and the heat in the environmental is not transferred into the telecommunication equipment room or cabinet through the integrated group of thermosiphons.

According to the above technical solution, heat dissipation of the outdoor communication device does not depend on the air conditioner and the energy consumption of the air conditioner is reduced, which improves the effects of energy saving and emission reduction. The temperature control device implements phase change heat dissipation by using the temperature difference, which reduces the drive and improves the maintainability.

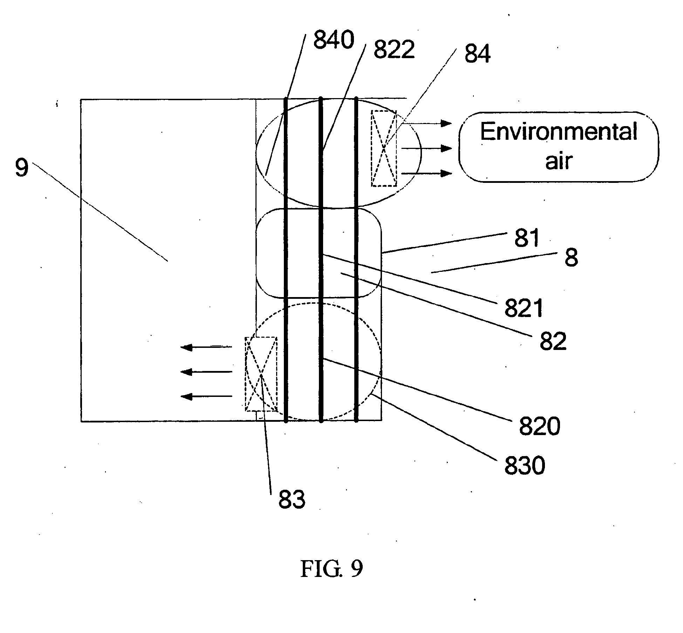

As shown in FIG 9, a communication device combination provided in an embodiment of the present invention includes a communication device 9 and a heat dissipation device 8, the heat dissipation device being configured to dissipate heat for the communication device 9. The heat dissipation device includes a cold storage medium module 81, an integrated group of thermosiphons 82, a first vent 830, and a second vent 840.

The integrated group of thermosiphons 82 are disposed through the cold storage medium module 81. The lower section 820 of the integrated group of thermosiphons 82 is disposed below the cold storage medium module 81 and in the first vent 830; the middle section 821 of the integrated group of thermosiphons 82 is disposed in the cold storage medium module; the upper section 822 of the integrated group of thermosiphons 82 is disposed above the cold storage medium module 81 and in the second vent 840. The heat produced by the communication device 9 is transferred to the lower section 820 of the integrated group of thermosiphons 82 by using the first vent 830. The upper section 822 of the integrated group of thermosiphons 82 exchanges the heat with the environmental air by using the second vent 840.

The structure and function of the heat dissipation device 8 have been described in the above embodiments, which are not detailed here again.

According to the above technical solution, heat dissipation of the outdoor communication device does not depend on the air conditioner and the energy consumption of the air conditioner is reduced, which improves the effects of energy saving and emission reduction. The temperature control device implements phase change heat dissipation by using the temperature difference, which reduces the drive and improves the maintainability.

The above are exemplary embodiments for illustrating the present invention, but the scope of the present invention is not limited to the embodiments. Variations or replacements are readily apparent to persons skilled in the art without departing from the protection scope of the present invention.

## Claims

1. A heat dissipation device (8) for a communication device, comprising: a closed shell (3) and a temperature control device (4), wherein the temperature control device (4) comprises:
a cold storage medium module (41), a first group of thermosiphons (42), a second group thermosiphons (43), and an auxiliary medium cooler (44); wherein the cold storage medium module (41) is disposed at the outside of the closed shell (3), the first group of thermosiphons (42) are provided with a first group of evaporation ends (421) and a first group of condensation ends (422), the second group of thermosiphons (43) are provided with a second group of evaporation ends (431) and a second group of condensation ends (432), and the auxiliary medium cooler (44) is connected to the cold storage medium module (41) by using a connection tube (45), wherein the cold storage medium module (41) is internally provided with a cold storage medium, and the first group of thermosiphons (42) and the second group of thermosiphons (43) are filled with thermally-vaporized liquid;
wherein the first group of evaporation ends (421) are disposed at the inside of the closed shell (3), and the first group of condensation ends (422) are disposed in the cold storage medium module (41); the second group of evaporation ends (431) are disposed in the cold storage medium module (41), and the second group of condensation ends (432) are disposed in environmental air; the first group of condensation ends (422) are disposed above the first group of evaporation ends (421) in the direction of gravity, and the second group of condensation ends (432) are disposed above the second group of evaporation ends (431) in the direction of gravity.

2. The heat dissipation device according to claim 1, wherein the cold storage medium comprises engineering liquid materials.

3. The heat dissipation device according to claim 1, wherein a shell of the cold storage medium module comprises thermal insulation materials and thermal-insulation protection layers.

4. The heat dissipation device according to claim 1, wherein the first group of thermosiphons and the second group of thermosiphons are made of metal.

5. The heat dissipation device according to claim 1, wherein the thermally-vaporized liquid comprises: ammonia, acetone, or R134A refrigerant.

6. The heat dissipation device according to claim 1, wherein the first group of evaporation ends are externally provided with fins and the second group of condensation ends are externally provided with fins.

7. A heat dissipation method for a communication device, comprising:
absorbing (S510) air heat inside the communication device by using a first group of evaporation ends of a first group of thermosiphons;
exchanging (S520) the air heat absorbed by a first group of evaporation ends with a cold storage medium module by using a first group of condensation ends of the first group of thermosiphons, and absorbing, by using a cold storage medium in the cold storage medium module, the heat emitted by the first group of condensation ends during a heat exchange, wherein the first group of condensation ends are disposed above the first group of evaporation ends in the direction of gravity;
absorbing (S530), by using a second group of evaporation ends of a second group of thermosiphons, the heat absorbed by the cold storage medium, and emitting, by using a second group of condensation ends of the second group of thermosiphons, the heat absorbed by the second group of evaporation ends to the environmental air, wherein the second group of condensation ends are disposed in the environmental air and are disposed above the second group of evaporation ends in the direction of gravity, and
providing a supplementary cold storage quantity for the cold storage medium module by using an auxiliary medium cooler,
wherein the cold storage medium module is internally provided with a cold storage medium, and the first group of thermosiphons and the second group of thermosiphons are filled with thermally-vaporized liquid.

8. The method according to claim 7, wherein the absorbing, by using the second group of evaporation ends of the second group of thermosiphons, the heat absorbed by the cold storage medium, and emitting, by using a second group of condensation ends of the second group of thermosiphons, the heat absorbed by the second group of evaporation ends to the environmental air, comprise:
absorbing the heat of the cold storage medium by using the second group of evaporation ends of the second group of thermosiphons to enable liquid in the second group of thermosiphons to evaporate into vapor;
transferring the vapor in the second group of thermosiphons to the second group of condensation ends of the second group of thermosiphons; and
exchanging heat between the vapor in the second group of condensation ends and the environmental air so as to liquefy the vapor in the second group of condensation ends, and emitting heat carried by the vapor into the environmental air.

9. A communication device, comprising: a at least one internal communication device (1) and a heat dissipation device (8) according to claim 1; wherein said internal communication device (1) is disposed at the inside of the closed shell (3), the temperature control device (4) is configured to enable the internal communication device (1) to run under an allowed temperature.

10. A heat dissipation device (8) for a communication device, comprising: a cold storage medium module (81), an integrated group of thermosiphons (82), a first vent (830), and a second vent (840); wherein
the integrated group of thermosiphons (82) are disposed through the cold storage medium module (81) in the direction of gravity; a lower section (820) of the integrated group of thermosiphons (82) is disposed below the cold storage medium module (81) and in the first vent (830); a middle section (821) of the integrated group of thermosiphons (82) is disposed in the cold storage medium module (81); an upper section (822) of the integrated group of thermosiphons (82) is disposed above the cold storage medium module (81) and in the second vent (840); heat produced by a communication device provided with the heat dissipation device (8) is transferred to the lower section (820) of the integrated group of thermosiphons (82) by using the first vent (830), the heat is deposited in the cold storage medium module (81) by using the middle section (821) of the integrated group of thermosiphons (82), and the heat deposited in the cold storage medium module (81) is exchanged by the upper section (822) of the integrated group of thermosiphons (82) with the environmental air by using the second vent (840),
wherein the cold storage medium module (81) is internally provided with a cold storage medium, and the integrated group of thermosiphons (82) are filled with thermally-vaporized liquid.

11. The heat dissipation device according to claim 10, wherein the first vent is provided with a first fan module and the second vent is provided with a second fan module.

12. The heat dissipation device according to claim 10, wherein an inner wall of the second vent is provided with a hole.

13. The heat dissipation device according to claim 10, wherein the cold storage medium in the cold storage medium module comprises: water, ice, ethylene glycol solution, or phase change material (PCM).

14. The heat dissipation device according to claim 10, wherein a shell of the cold storage medium module comprises thermal insulation materials and thermal-insulation protection layers.

15. The heat dissipation device according to claim 10, wherein the thermally-vaporized liquid comprises: ammonia, acetone, or R134A refrigerant.

16. A communication device combination, comprising a communication device (9), and a heat dissipation device (8) according to claim 10.

## Patentansprüche

1. Wärmeableitvorrichtung (8) für eine Kommunikationsvorrichtung, wobei die Wärmeableitvorrichtung Folgendes umfasst: eine geschlossene Kapsel (3) und eine Temperatursteuervorrichtung (4), wobei die Temperatursteuervorrichtung (4) Folgendes umfasst:
ein Kältespeichermediummodul (41), eine erste Gruppe von Thermosiphons (42), eine zweite Gruppe von Thermosiphons (43) und einen Zusatzmediumkühler (44), wobei das Kältespeichermediummodul (41) auf der Außenseite der geschlossenen Kapsel (3) angeordnet ist, wobei die erste Gruppe von Thermosiphons (42) mit einer ersten Gruppe von Verdampfungsenden (421) und einer ersten Gruppe von Kondensationsenden (422) versehen ist, wobei die zweite Gruppe von Thermosiphons (43) mit einer zweiten Gruppe von Verdampfungsenden (431) und einer zweiten Gruppe von Kondensationsenden (432) versehen ist und wobei der Zusatzmediumkühler (44) mit dem Kältespeichermediummodul (41) unter Verwendung eines Verbindungsrohrs (45) verbunden ist, wobei das Kältespeichermediummodul (41) innen mit einem Kältespeichermedium versehen ist und wobei die erste Gruppe von Thermosiphons (42) und die zweite Gruppe von Thermosiphons (43) mit thermisch verdampfter Flüssigkeit gefüllt sind;
wobei die erste Gruppe von Verdampfungsenden (421) auf der Innenseite der geschlossenen Kapsel (3) angeordnet ist und die erste Gruppe von Kondensationsenden (422) in dem Kältespeichermediummodul (41) angeordnet ist; wobei die zweite Gruppe von Verdampfungsenden (431) in dem Kältespeichermediummodul (41) angeordnet ist und wobei die zweite Gruppe von Kondensationsenden (432) in der Umgebungsluft angeordnet ist; wobei die erste Gruppe von Kondensationsenden (422) in Richtung der Schwerkraft über der ersten Gruppe von Verdampfungsenden (421) angeordnet ist und die zweite Gruppe von Kondensationsenden (432) in Richtung der Schwerkraft über der zweiten Gruppe von Verdampfungsenden (431) angeordnet ist.

2. Wärmeableitvorrichtung nach Anspruch 1, wobei das Kältespeichermedium technische Flüssigmaterialien umfasst.

3. Wärmeableitvorrichtung nach Anspruch 1, wobei eine Kapsel des Kältespeichermediummoduls Wärmedämmmaterialien und Wärmedämmschutzschichten umfasst.

4. Wärmeableitvorrichtung nach Anspruch 1, wobei die erste Gruppe von Thermosiphons und die zweite Gruppe von Thermosiphons aus Metall hergestellt sind.

5. Wärmeableitvorrichtung nach Anspruch 1, wobei die thermisch verdampfte Flüssigkeit Folgendes umfasst: Ammoniak, Aceton oder Kühlmittel R134A.

6. Wärmeableitvorrichtung nach Anspruch 1, wobei die erste Gruppe von Verdampfungsenden außen mit Rippen versehen ist und die zweite Gruppe von Kondensationsenden außen mit Rippen versehen ist.

7. Wärmeableitverfahren für eine Kommunikationsvorrichtung, wobei das Verfahren Folgendes umfasst:
Aufnehmen (S510) von Luftwärme innerhalb der Kommunikationsvorrichtung unter Verwendung einer ersten Gruppe von Verdampfungsenden einer ersten Gruppe von Thermosiphons;
Austauschen (S520) der durch eine erste Gruppe von Verdampfungsenden aufgenommenen Luftwärme mit einem Kältespeichermediummodul unter Verwendung einer ersten Gruppe von Kondensationsenden der ersten Gruppe von Thermosiphons und Aufnehmen der durch die erste Gruppe von Kondensationsenden während eines Wärmeaustauschs ausgesendeten Wärme unter Verwendung eines Kältespeichermediums in dem Kältespeichermediummodul, wobei die erste Gruppe von Kondensationsenden in Richtung der Schwerkraft über der ersten Gruppe von Verdampfungsenden angeordnet ist;
Aufnehmen (S530) der durch das Kältespeichermedium aufgenommenen Wärme unter Verwendung einer zweiten Gruppe von Verdampfungsenden einer zweiten Gruppe von Thermosiphons und Aussenden der durch die zweite Gruppe von Verdampfungsenden aufgenommenen Wärme an die Umgebungsluft unter Verwendung einer zweiten Gruppe von Kondensationsenden der zweiten Gruppe von Thermosiphons, wobei die zweite Gruppe von Kondensationsenden in der Umgebungsluft angeordnet ist und in Richtung der Schwerkraft über der zweiten Gruppe von Verdampfungsenden angeordnet ist, und
Bereitstellen einer Zusatzkältespeichermenge für das Kältespeichermediummodul unter Verwendung eines Zusatzmediumkühlers,
wobei das Kältespeichermediummodul innen mit einem Kältespeichermedium versehen ist und wobei die erste Gruppe von Thermosiphons und die zweite Gruppe von Thermosiphons mit thermisch verdampfter Flüssigkeit gefüllt sind.

8. Verfahren nach Anspruch 7, wobei das Aufnehmen der durch das Kältespeichermedium aufgenommenen Wärme unter Verwendung der zweiten Gruppe von Verdampfungsenden der zweiten Gruppe von Thermosiphons und das Aussenden der durch die zweite Gruppe von Verdampfungsenden aufgenommenen Wärme an die Umgebungsluft unter Verwendung einer zweiten Gruppe von Kondensationsenden der zweiten Gruppe von Thermosiphons Folgendes umfasst:
Aufnehmen der Wärme des Kältespeichermediums unter Verwendung der zweiten Gruppe von Verdampfungsenden der zweiten Gruppe von Thermosiphons, um zu ermöglichen, dass Flüssigkeit in der zweiten Gruppe von Thermosiphons zu Dampf verdampft;
Übertragen des Dampfs in der zweiten Gruppe von Thermosiphons an die zweite Gruppe von Kondensationsenden der zweiten Gruppe von Thermosiphons; und
Austauschen von Wärme zwischen dem Dampf in der zweiten Gruppe von Kondensationsenden und der Umgebungsluft, um den Dampf in der zweiten Gruppe von Kondensationsenden zu verflüssigen, und Aussenden der durch den Dampf geführten Wärme an die Umgebungsluft.

9. Kommunikationsvorrichtung, die Folgendes umfasst: wenigstens eine interne Kommunikationsvorrichtung (1) und eine Wärmeableitvorrichtung (8) nach Anspruch 1; wobei die interne Kommunikationsvorrichtung (1) auf der Innenseite der geschlossenen Kapsel (3) angeordnet ist, wobei die Temperatursteuervorrichtung (4) dafür konfiguriert ist zu ermöglichen, dass die interne Kommunikationsvorrichtung (1) unter einer zulässigen Temperatur arbeitet.

10. Wärmeableitvorrichtung (8) für eine Kommunikationsvorrichtung, wobei die Wärmeableitvorrichtung Fol gendes umfasst: ein Kältespeichermediummodul (81), eine integrierte Gruppe von Thermosiphons (82), eine erste Entlüftungsöffnung (830) und eine zweite Entlüftungsöffnung (840); wobei
die integrierte Gruppe von Thermosiphons (82) in Richtung der Schwerkraft durch das Kältespeichermediummodul (81) angeordnet ist; wobei ein unterer Abschnitt (820) der integrierten Gruppe von Thermosiphons (82) unter dem Kältespeichermediummodul (81) und in der ersten Entlüftungsöffnung (830) angeordnet ist; wobei ein mittlerer Abschnitt (821) der integrierten Gruppe von Thermosiphons (82) in dem Kältespeichermediummodul (81) angeordnet ist; wobei ein oberer Abschnitt (822) der integrierten Gruppe von Thermosiphons (82) über dem Kältespeichermediummodul (81) und in der zweiten Entlüftungsöffnung (840) angeordnet ist; wobei durch eine mit der Wärmeableitvorrichtung (8) versehene Kommunikationsvorrichtung erzeugte Wärme unter Verwendung der ersten Entlüftungsöffnung (830) an den unteren Abschnitt (820) der integrierten Gruppe von Thermosiphons (82) übertragen wird, wobei die Wärme unter Verwendung des mittleren Abschnitts (821) der integrierten Gruppe von Thermosiphons (82) in dem Kältespeichermediummodul (81) aufbewahrt wird und wobei die in dem Kältespeichermediummodul (81) aufbewahrte Wärme unter Verwendung der zweiten Entlüftungsöffnung (840) durch den oberen Abschnitt (822) der integrierten Gruppe von Thermosiphons (82) mit der Umgebungsluft ausgetauscht wird,
wobei das Kältespeichermediummodul (81) innen mit einem Kältespeichermedium versehen ist und die integrierte Gruppe von Thermosiphons (82) mit thermisch verdampfter Flüssigkeit gefüllt ist.

11. Wärmeableitvorrichtung nach Anspruch 10, wobei die erste Entlüftungsöffnung mit einem ersten Lüftermodul versehen ist und die zweite Entlüftungsöffnung mit einem zweiten Lüftermodul versehen ist.

12. Wärmeableitvorrichtung nach Anspruch 10, wobei eine Innenwand der zweiten Entlüftungsöffnung mit einem Loch versehen ist.

13. Wärmeableitvorrichtung nach Anspruch 10, wobei das Kältespeichermedium in dem Kältespeichermediummodul Folgendes umfasst: Wasser, Eis, Ethylenglykollösung oder ein Phasenänderungsmaterial (PCM).

14. Wärmeableitvorrichtung nach Anspruch 10, wobei eine Kapsel des Kältespeichermediummoduls Wärmedämmmaterialien und Wärmedämmschutzschichten umfasst.

15. Wärmeableitvorrichtung nach Anspruch 10, wobei die thermisch verdampfte Flüssigkeit Folgendes umfasst: Ammoniak, Aceton oder Kühlmittel R134A.

16. Kommunikationsvorrichtungskombination, die eine Kommunikationsvorrichtung (9) und eine Wärmeableitvorrichtung (8) nach Anspruch 10 umfasst.

## Revendications

1. Dispositif (8) de dissipation thermique pour un dispositif de communication, comportant : une coque fermée (3) et un dispositif (4) de régulation de température, le dispositif (4) de régulation de température comportant :
un module (41) pour milieu de stockage de froid, un premier groupe de thermosiphons (42), un deuxième groupe de thermosiphons (43) et un refroidisseur auxiliaire (44) de milieu; le module (41) pour milieu de stockage de froid étant disposé à l'extérieur de la coque fermée (3), le premier groupe de thermosiphons (42) étant muni d'un premier groupe d'extrémités (421) d'évaporation et d'un premier groupe d'extrémités (422) de condensation, le deuxième groupe de thermosiphons (43) étant muni d'un deuxième groupe d'extrémités (431) d'évaporation et un deuxième groupe d'extrémités (432) de condensation et le refroidisseur auxiliaire (44) de milieu étant relié au module (41) pour milieu de stockage de froid en utilisant un tube (45) de liaison, le module (41) pour milieu de stockage de froid étant muni intérieurement d'un milieu de stockage de froid et le premier groupe de thermosiphons (42) et le deuxième groupe de thermosiphons (43) étant remplis de liquide vaporisé thermiquement ;
le premier groupe d'extrémités (421) d'évaporation étant disposé à l'intérieur de la coque fermée (3) et le premier groupe d'extrémités (422) de condensation étant disposé dans le module (41) pour milieu de stockage de froid ; le deuxième groupe d'extrémités (431) d'évaporation étant disposé dans le module (41) pour milieu de stockage de froid et le deuxième groupe d'extrémités (432) de condensation étant disposé dans l'air ambiant ; le premier groupe d'extrémités (422) de condensation étant disposé au-dessus du premier groupe d'extrémités (421) d'évaporation dans le sens de la gravité et le deuxième groupe d'extrémités (432) de condensation étant disposé au-dessus du deuxième groupe d'extrémités (431) d'évaporation dans le sens de la gravité.

2. Dispositif de dissipation thermique selon la revendication 1, le milieu de stockage de froid comportant des matériaux liquides techniques.

3. Dispositif de dissipation thermique selon la revendication 1, une coque du module pour milieu de stockage de froid comportant des matériaux d'isolation thermique et des couches de protection d'isolation thermique.

4. Dispositif de dissipation thermique selon la revendication 1, le premier groupe de thermosiphons et le deuxième groupe de thermosiphons étant constitués de métal.

5. Dispositif de dissipation thermique selon la revendication 1, le liquide vaporisé thermiquement comportant : de l'ammoniac, de l'acétone ou de l'agent frigorigène R134A.

6. Dispositif de dissipation thermique selon la revendication 1, le premier groupe d'extrémités d'évaporation étant muni extérieurement d'ailettes et le deuxième groupe d'extrémités de condensation étant muni extérieurement d'ailettes.

7. Procédé de dissipation thermique pour dispositif de communication, comportant les étapes consistant à :
absorber (S510) de la chaleur d'air à l'intérieur du dispositif de communication en utilisant un premier groupe d'extrémités d'évaporation d'un premier groupe de thermosiphons ;
échanger (S520) la chaleur d'air absorbée par un premier groupe d'extrémités d'évaporation à l'aide d'un module pour milieu de stockage de froid en utilisant un premier groupe d'extrémités de condensation du premier groupe de thermosiphons et absorber, en utilisant un milieu de stockage de froid dans le module pour milieu de stockage de froid, la chaleur émise par le premier groupe d'extrémités de condensation au cours d'un échange de chaleur, le premier groupe d'extrémités de condensation étant disposé au-dessus du premier groupe d'extrémités d'évaporation dans le sens de la gravité ;
absorber (S530), en utilisant un deuxième groupe d'extrémités d'évaporation d'un deuxième groupe de thermosiphons, la chaleur absorbée par le milieu de stockage de froid et émettre, en utilisant un deuxième groupe d'extrémités de condensation du deuxième groupe de thermosiphons, la chaleur absorbée par le deuxième groupe d'extrémités d'évaporation vers l'air ambiant, le deuxième groupe d'extrémités de condensation étant disposé dans l'air ambiant et étant disposé au-dessus du deuxième groupe d'extrémités d'évaporation dans le sens de la gravité, et
apporter une quantité supplémentaire de stockage de froid au module pour milieu de stockage de froid en utilisant un refroidisseur auxiliaire de milieu,
le module pour milieu de stockage de froid étant muni intérieurement d'un milieu de stockage de froid, et le premier groupe de thermosiphons et le deuxième groupe de thermosiphons étant remplis de liquide vaporisé thermiquement.

8. Procédé selon la revendication 7, l'absorption, à l'aide du deuxième groupe d'extrémités d'évaporation du deuxième groupe de thermosiphons, de la chaleur absorbée par le milieu de stockage de froid et l'émission, à l'aide d'un deuxième groupe d'extrémités de condensation du deuxième groupe de thermosiphons, de la chaleur absorbée par le deuxième groupe d'extrémités d'évaporation vers l'air ambiant, comportant les étapes consistant à :
absorber la chaleur du milieu de stockage de froid à l'aide du deuxième groupe d'extrémités d'évaporation du deuxième groupe de thermosiphons pour permettre à du liquide présent dans le deuxième groupe de thermosiphons de s'évaporer en donnant une vapeur ;
transférer la vapeur présente dans le deuxième groupe de thermosiphons au deuxième groupe d'extrémités de condensation du deuxième groupe de thermosiphons ; et
échanger de la chaleur entre la vapeur présente dans le deuxième groupe d'extrémités de condensation et l'air ambiant de façon à liquéfier la vapeur présente dans le deuxième groupe d'extrémités de condensation et émettre la chaleur transportée par la vapeur dans l'air ambiant.

9. Dispositif de communication, comportant : au moins un dispositif interne (1) de communication et un dispositif (8) de dissipation thermique selon la revendication 1 ; ledit dispositif interne (1) de communication étant disposé à l'intérieur de la coque fermée (3), le dispositif (4) de régulation de température étant configuré pour permettre au dispositif interne (1) de communication de fonctionner sous une température admise.

10. Dispositif (8) de dissipation thermique pour un dispositif de communication, comportant : un module (81) pour milieu de stockage de froid, un groupe intégré de thermosiphons (82), un premier évent (830) et un deuxième évent (840) ;
le groupe intégré de thermosiphons (82) étant disposé à travers le module (81) pour milieu de stockage de froid dans le sens de la gravité ; une section inférieure (820) du groupe intégré de thermosiphons (82) étant disposée au-dessous du module (81) pour milieu de stockage de froid et dans le premier évent (830) ; une section médiane (821) du groupe intégré de thermosiphons (82) étant disposée dans le module (81) pour milieu de stockage de froid ; une section supérieure (822) du groupe intégré de thermosiphons (82) étant disposée au-dessus du module (81) pour milieu de stockage de froid et dans le deuxième évent (840) ; la chaleur produite par un dispositif de communication muni du dispositif (8) de dissipation thermique étant transférée à la section inférieure (820) du groupe intégré de thermosiphons (82) en utilisant le premier évent (830), la chaleur étant déposée dans le module (81) pour milieu de stockage de froid en utilisant la section médiane (821) du groupe intégré de thermosiphons (82) et la chaleur déposée dans le module (81) pour milieu de stockage de froid étant échangée par la section supérieure (822) du groupe intégré de thermosiphons (82) avec l'air ambiant en utilisant le deuxième évent (840),
le module (81) pour milieu de stockage de froid étant muni intérieurement d'un milieu de stockage de froid et le groupe intégré de thermosiphons (82) étant rempli d'un liquide vaporisé thermiquement.

11. Dispositif de dissipation thermique selon la revendication 10, le premier évent étant muni d'un premier module de ventilateur et le deuxième évent étant muni d'un deuxième module de ventilateur.

12. Dispositif de dissipation thermique selon la revendication 10, une paroi intérieure du deuxième évent étant munie d'un trou.

13. Dispositif de dissipation thermique selon la revendication 10, le milieu de stockage de froid présent dans le module pour milieu de stockage de froid comportant : de l'eau, de la glace, une solution d'éthylène glycol ou un matériau à changement de phase (PCM).

14. Dispositif de dissipation thermique selon la revendication 10, une coque du module pour milieu de stockage de froid comportant des matériaux d'isolation thermique et des couches de protection d'isolation thermique.

15. Dispositif de dissipation thermique selon la revendication 10, le liquide vaporisé thermiquement comportant : de l'ammoniac, de l'acétone ou de l'agent frigorigène R134A.

16. Combinaison de dispositif de communication, comportant un dispositif de communication (9) et un dispositif (8) de dissipation thermique selon la revendication 10.
